(19) Europäisches Patentamt
European Patent Office
Office européen des brevets

(11) **EP 4 206 691 B1**

(12) **EUROPEAN PATENT SPECIFICATION**

(45) Date of publication and mention
of the grant of the patent:
**07.05.2025  Bulletin 2025/19**

(21) Application number: **22862740.2**

(22) Date of filing: **18.05.2022**

(51) International Patent Classification (IPC):
**G01R 19/00** *(2006.01)*    **G05B 19/042** *(2006.01)*
**G01R 15/20** *(2006.01)*    **G01R 15/18** *(2006.01)*

(52) Cooperative Patent Classification (CPC):
**G05B 19/042; G01R 15/207; G01R 15/185**

(86) International application number:
**PCT/CN2022/093583**

(87) International publication number:
**WO 2023/029598 (09.03.2023 Gazette 2023/10)**

(54) **LOW-POWER-CONSUMPTION INTELLIGENT CURRENT SENSOR AND WORKING MODE CONTROL METHOD THEREFOR**

INTELLIGENTER STROMSENSOR MIT GERINGEM ENERGIEVERBRAUCH UND BETRIEBSMODUSSTEUERUNGSVERFAHREN DAFÜR

CAPTEUR DE COURANT INTELLIGENT À FAIBLE CONSOMMATION D'ÉNERGIE ET SON PROCÉDÉ DE COMMANDE EN MODE DE FONCTIONNEMENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.09.2021  CN 202111035826**

(43) Date of publication of application:
**05.07.2023  Bulletin 2023/27**

(73) Proprietor: **Jiangsu Changrong Electrical Appliance Co., Ltd.**
**Changzhou, Jiangsu 213031 (CN)**

(72) Inventors:
• **MIN, Xiang**
**Changzhou, Jiangsu 213031 (CN)**
• **KUANG, Chengxiao**
**Changzhou, Jiangsu 213031 (CN)**
• **ZOU, Jinhua**
**Changzhou, Jiangsu 213031 (CN)**
• **FAN, Wenlu**
**Changzhou, Jiangsu 213031 (CN)**

(74) Representative: **Thoma, Michael**
**Lorenz Seidler Gossel**
**Rechtsanwälte Patentanwälte**
**Partnerschaft mbB**
**Widenmayerstraße 23**
**80538 München (DE)**

(56) References cited:
**CN-A- 113 466 534      CN-U- 205 157 695**
**CN-U- 209 911 469      CN-U- 212 483 673**
**CN-U- 212 483 673      JP-A- 2010 175 276**
**KR-A- 20150 040 100     US-A- 5 552 979**
**US-A1- 2020 310 477**

## Description

### TECHNICAL FIELD

The present disclosure belongs to the field of current sensor technologies, and specifically, relates to a low-power intelligent current sensor and a control method of an operating mode thereof.

### BACKGROUND

A conventional close-loop current sensor usually includes a magnetic sensor, a secondary coil, and a drive circuit. The magnetic sensor includes, for example, a Hall effect probe, a magnetoresistance effect probe, and a fluxgate probe. There is a soft magnetic core with high permeability in the secondary coil. When a current in a primary conductor generates a magnetic field around the conductor, the magnetic sensor converts an induced magnetic field signal into an electrical signal, to drive a secondary compensation coil to generate a magnetic field that is opposite to and has the same magnitude as a primary current magnetic field in the soft magnetic core, magnitude of an obtained secondary current being related to an amplitude of a primary current. According to the above principle, the current sensor can implement a high-voltage insulation design of primary-secondary coils and a high-precision measurement. The technology is widely applied to current measurements in robots, new energy vehicles, and other industrial sites.

However, when a current is measured, the existing close-loop current sensor needs current supply to generate a magnetic field on the secondary coil to balance the magnetic field, which is generated by the primary current. Therefore, heat is generated, and the heat increases with an increase in the primary current. In order to reduce the temperature rise of the current sensor and ensure that the current sensor can work reliably for a long time, the current sensor is usually potted with a glue of excellent thermal conductivity, so as to dissipate the heat. However, using the thermally conductive glue not only increases production costs and weight of the current sensor, but also increases pressure on environmental protection. In addition, when there is no primary current, this type of current sensor still consumes the current, and standby power consumption is relatively high, resulting in unnecessary waste of energy. Moreover, in some application scenarios, a power supply voltage of the current sensor fluctuates within a relatively large voltage range. Under the premise that the volume of the sensor is not increased, the full scale of the current sensor is often limited by a lower limit of the power supply voltage.

Document CN 212 483 673 U discloses a low-power-consumption closed-loop Hall current sensor. This sensor comprises a magnetic core, a primary side wire, a feedback coil and a Hall element arranged in an air gap of the magnetic core.

### SUMMARY

The existing current sensors have 3 problems: over heat, high standby power consumption and a full scale limited by its minimum power supply. In order to solve these problems, the present disclosure discloses a low-power intelligent current sensor and a control method of an operating mode, thereby reducing heat generation and standby power consumption of a close-loop current sensor, and regulating the power supply voltage to a proper value, so as to increase the full scale of the sensor.

The main technical solutions used in the present disclosure are as follows:

A low-power intelligent current sensor is provided, including a magnetic core, a secondary coil wound around the magnetic core, and a magnetic sensor disposed in the magnetic core, and further including a current detection circuit, the current detection circuit including a power supply module, a drive module, a microcontroller, a temperature detection module, and a signal input/output interface module, a signal output terminal of the magnetic sensor being connected to a signal input terminal of the drive module, the drive module being electrically connected to each of two ends of the secondary coil, the microcontroller being in signal connection to each of the power supply module, the drive module, the temperature detection module, and the signal input/output interface module, the power supply module being connected to each of the drive module, the microcontroller, the temperature detection module, and the signal input/output interface module, an input terminal and an output terminal of the signal input/output interface module being each in signal connection to a client, and the temperature detection module being installed in the current sensor, and being configured for detecting a temperature of the current sensor.

Preferably, the power supply module includes a direct current to direct current (DC-DC) converter, a first linear regulator, and a second linear regulator; input terminals of the DC-DC converter, the first linear regulator, and the second linear regulator are all connected to a power supply voltage Vcc of the current sensor; an output voltage U1 of the DC-DC converter is electrically connected to the secondary coil through the drive module; an output voltage U2 of the first linear regulator is electrically connected to each of the drive module, the temperature detection module, and the signal input/output interface module; an output voltage U3 of the second linear regulator is electrically connected to a power supply of the microcontroller; and three power supply circuits in the power supply module are all controlled by the microcontroller.

Preferably, the signal input/output interface module is replaced with a signal output interface module, and in addition, a wake-up port is further disposed, the wake-up port being in signal connection to the microcontroller.

An operating mode control method of the low-power intelligent current sensor is provided, where a normal operating mode, a low-power mode, a standby mode, and a sleep mode are included. The specific control method is as follows:

The normal operating mode: The current sensor enters the normal operating mode after being powered on. In this case, the microcontroller controls the power supply module to continuously supply power to the secondary coil, and monitors a temperature of the current sensor in real time through the temperature detection module. The microcontroller acquires current information of a sampling resistor in the drive module in real time, calculates a primary current according to the acquired current information, and outputs a current measurement result to the client through the signal input/output interface module or the signal output interface module. The microcontroller controls the current sensor to exit from the normal operating mode and enter another mode according to an external command or an internal trigger condition.

The low-power mode: During a process of temperature rise, when the temperature detection module detects that the temperature of the current sensor is greater than a preset temperature threshold $T_1$, the current sensor enters the low-power mode. Within each preset current measurement cycle, the microcontroller controls the power supply module to perform a power-on and power-off operation on the secondary coil, wherein the current sensor is powered off immediately after completing current measurement within a power-on cycle of the secondary coil. During a process of temperature drop, when the temperature detection module detects that the temperature of the current sensor is less than a preset temperature threshold $T_2$, the microcontroller controls the current sensor to enter the normal operating mode or the standby mode.

The standby mode: When the current sensor is in the normal operating mode or the low-power mode, after an absolute value of the primary current is less than a preset current threshold $I_1$ for a predetermined time t, the current sensor enters the standby mode. In the standby mode, a temperature sensor monitors the temperature of the current sensor in real time, and the microcontroller monitors the primary current but does not transmit a signal to the client. When the absolute value of the primary current is greater than the current threshold $I_1$, the current sensor automatically returns to the normal operating mode, and the microcontroller transmits a current measurement result to outside.

The sleep mode: After a period of time t' in the standby mode, the current sensor enters the sleep mode. The microcontroller controls the power supply module to power off the secondary coil, the temperature sensor, and the drive module. The signal input/output interface module or the wake-up port is in a monitoring mode. The temperature sensor stops working. The microcontroller works in the sleep mode, and monitors only the signal input/output interface module or the wake-up port, to receive a client command. The client inputs a wake-up signal through the input/output interface module or the wake-up port, and the microcontroller controls the current sensor to enter the normal operating mode according to the wake-up command.

Beneficial effects: The present disclosure provides a low-power intelligent current sensor and an operating mode control method thereof, which have the following advantages:

(1) With an appropriate control strategy, the heat generation of existing close-loop current sensor is reduced and the overheating problem is solved.
(2) The power consumption is reduced by control of the operating status of each component using the microcontroller.
(3) The DC-DC converter regulates the power supply voltage Vcc to a proper value to increase the full scale of current sensor.
(4) The use of the microcontroller to control the power module to supply power to the components respectively allows for the intelligent control of the current sensor.

**BRIEF DESCRIPTION OF THE DRAWINGS**

FIG. 1 is a schematic diagram of an internal structure of a current sensor in Embodiment 1.
FIG. 2 is a schematic diagram of an operating mode of Embodiment 1.
FIG. 3 is a schematic diagram of a normal operating mode of Embodiment 1.
FIG. 4 is a schematic diagram of a standby mode of Embodiment 1.
FIG. 5 is a schematic diagram of comparison of power consumption between Embodiment 1 and a conventional current sensor.
FIG. 6 is a diagram of a circuit structure of a drive module in Embodiment 1.
FIG. 7 is a schematic diagram of an internal structure of a current sensor in Embodiment 2.

In the figures: magnetic core 1, secondary coil 2, magnetic sensor 3, and primary conductor 4.

## DETAILED DESCRIPTION

To enable a person skilled in the art to better understand the technical solutions of this application, the technical solutions of the embodiments of this application will be described clearly and thoroughly below. Apparently, the described embodiments are merely a part rather than all of the embodiments of this application. All other embodiments obtained by a person of ordinary skill in the art based on the embodiments of this application without creative efforts shall fall within the protection scope of this application.

Embodiment 1

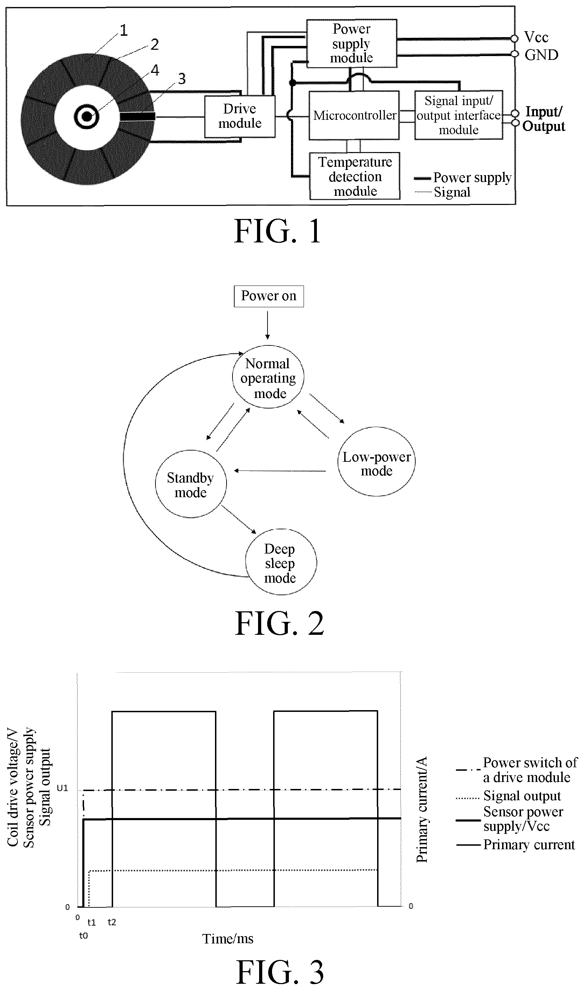

As shown in FIG. 1, a low-power intelligent current sensor includes a magnetic core 1, a secondary coil 2 wound around the magnetic core 1, a magnetic sensor 3 disposed in the magnetic core 1, and a current detection circuit. The current detection circuit includes a power supply module, a drive module, a microcontroller, a temperature detection module, and a signal input/output interface module. A signal output terminal of the magnetic sensor 3 is connected to a signal input terminal of the drive module. The drive module is connected to each of two ends of the secondary coil 2. The microcontroller is in signal connection to the power supply module, the drive module, the temperature detection module, and the signal input/output interface module. An input terminal and an output terminal of the signal input/output interface module are each in signal connection to a client. The temperature detection module is installed in the current sensor, and is configured for detecting temperature of the current sensor. The power supply module includes a DC-DC converter, a first linear regulator, and a second linear regulator. Input terminals of the DC-DC converter, the first linear regulator, and the second linear regulator are all connected to the power supply voltage Vcc of the current sensor. An output voltage U1 of the DC-DC converter is electrically connected to the secondary coil 2 through the drive module. An output voltage U2 of the first linear regulator is connected to each of the drive module, the temperature detection module, and the signal input/output interface module. An output voltage U3 of the second linear regulator is connected to the microcontroller.

In Embodiment 1, the power supply voltage Vcc of the current sensor fluctuates between Vcc1 and Vcc2 (Vcc1≠Vcc2). The value of U1 is determined by the maximum primary current $Ip_{max}$ of the secondary coil and the voltage drop $U_{drop}$ of the drive module. The magnitude of U1 can be adjusted according to a formula (1). Therefore, the full scale of the current sensor is not limited by the power supply voltage Vcc of the current sensor.

$$U1 \geq R_c * Ip_{max} + U_{drop} \qquad (1).$$

In the formula (1), $R_c$ is a maximum secondary coil resistance.

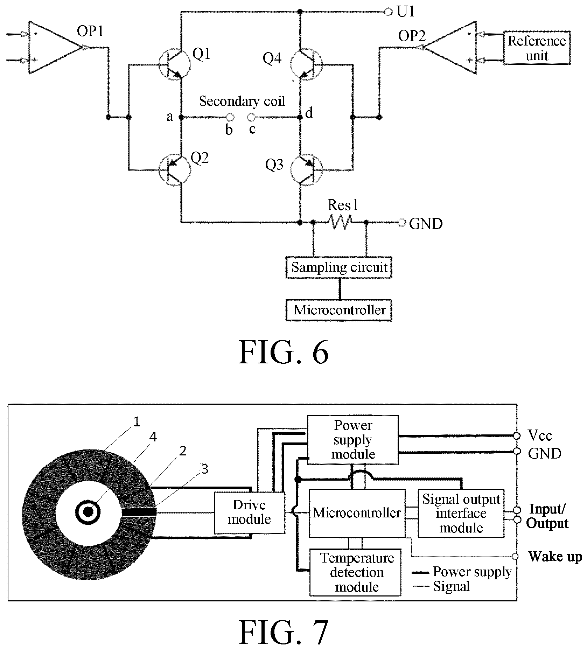

A circuit structure of the drive module in Embodiment 1, as shown in FIG. 6, includes a first operational amplifier OP1, a second operational amplifier OP2, $M_1$ first NPN transistors Q1, $M_2$ first PNP transistors Q2, $M_3$ second NPN transistors Q4, $M_4$ second PNP transistors Q3, and a sampling resistor Res1, and $M_1$, $M_2$, $M_3$, and $M_4$ are all 1. An input terminal of the first operational amplifier OP1 is connected to a signal output terminal of the magnetic sensor 3. An emitter of the first NPN transistor Q1 and an emitter of the first PNP transistor Q2 are connected to a terminal b of the secondary coil 2 after being connected to a terminal a. An emitter of the second NPN transistor Q4 and an emitter of the second PNP transistor Q3 are connected to a terminal c of the secondary coil 2 after being connected to a terminal d. The sampling resistor Res1 is connected to an external sampling circuit (which belongs to a conventional technology and is not described in detail), and the sampling circuit transmits an acquired current signal to the microcontroller for calculation, so as to obtain magnitude of the primary current.

The working principle of Embodiment 1 is as follows:

During measurement, a primary current $I_p$ flows through the primary conductor 4 and passes through the magnetic core 1 to generate a magnetic field. Then, the magnetic sensor 3 converts a magnetic signal into an electrical signal and outputs the electrical signal to the drive module, to trigger the drive module to work. The power supply module outputs U1 to supply power to the secondary coil 2 through the drive module, to enable a magnetic field that has the same magnitude as and is opposite to a primary current magnetic field to be generated in the magnetic core 1, so that magnetic induction intensity in the magnetic core 1 remains zero. The microcontroller acquires a secondary current through the sampling resistor of the drive module, calculates the acquired secondary current signal to obtain magnitude of the primary current, and then transmits the signal to the client through the signal input/output interface module. The client also inputs a command to the microcontroller through the signal input/output interface module, and the microcontroller controls the current sensor to enter a corresponding operating mode according to the command. The power supply voltage Vcc of the current sensor fluctuates between Vcc1 and Vcc2, the DC-DC converter in the power supply module converts the power supply voltage Vcc of the current sensor into U1, to supply power to the secondary coil 2. Moreover, the power supply module supplies power to each of the drive module, the signal input/output interface module, and the temperature detection module through the output U2 of the first linear regulator (LDO). The power supply module supplies power to the microcontroller through the output U3 of the second linear regulator (LDO). A temperature controller detects a working temperature of the current sensor in real time, and transmits an acquired temperature signal to the microcontroller. The microcontroller controls the current sensor to enter a corresponding operating mode according to the received temperature signal. The power supply circuit of the power supply module is controlled to be on or off by the microcontroller.

As shown in FIG. 2, a control method of four operating modes of Embodiment 1 is as follows:

The normal operating mode: The current sensor enters the normal operating mode after being powered on. In this case, the microcontroller controls the power supply module to continuously supply power to the secondary coil 2, and monitors temperature of the current sensor through the temperature detection module. The microcontroller outputs a measurement result of the current through the signal input/output interface module. The microcontroller controls the drive module to exit from the normal operating mode and enter another mode according to an external command or an internal trigger condition.

As shown in FIG. 3, at a moment $t_0$, the power supply voltage Vcc of the current sensor is powered on, and the microcontroller controls the drive module to supply power U1 to the secondary coil 2. At a moment $t_1$, the drive module starts to provide power to the secondary coil and the micro controller acquires the current of the secondary coil. The current measurement is started. At a moment $t_2$, the primary current is on. The microcontroller calculates magnitude of the primary current according to the acquired secondary current signal, and outputs a measured value of the primary current to the client through the signal input/output interface module. During a whole measuring process, the drive module, the secondary coil 2, the temperature detection module, the microcontroller, and the signal input/output interface module are always being powered on.

The low-power mode: During a process of temperature rise, when the temperature detection module detects that the temperature of the current sensor is greater than a preset temperature threshold $T_1$, the current sensor enters the low-power mode. Within each preset current measurement cycle, the microcontroller controls the power supply module to perform a power-on and power-off operation on the secondary coil 2, and the current sensor is powered off immediately after completing current measurement within a power-on cycle of the secondary coil 2. During a process of temperature drop, when the temperature detection module detects that the temperature of the current sensor is less than a preset temperature threshold $T_2$, the microcontroller controls the current sensor to enter the normal operating mode or the standby mode.

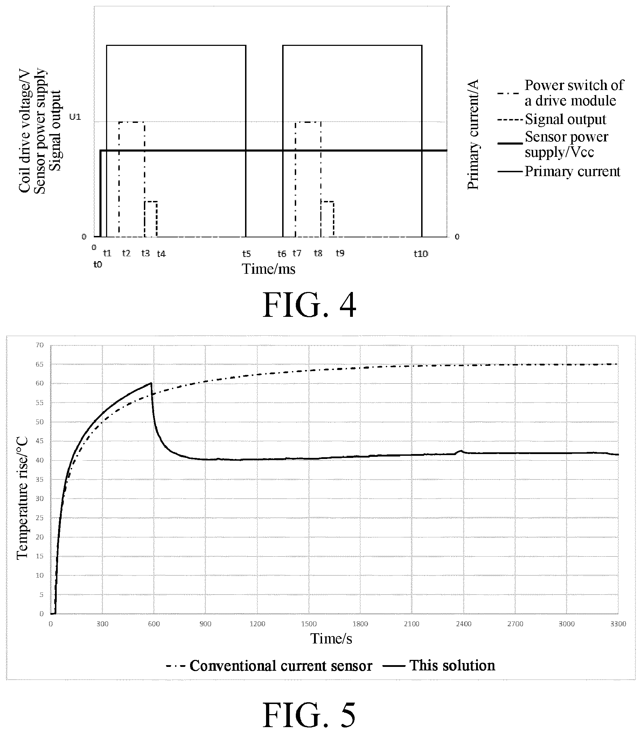

As shown in FIG. 4, a preset current measurement cycle starts at a moment $t_0$ and ends at a moment $t_5$. At the moment $t_0$, the power supply voltage Vcc of the current sensor is powered on. At a moment $t_1$, the primary current is inputted to the primary conductor 4. At a moment $t_2$, the microcontroller controls the drive module to supply power to the secondary coil 2. At a moment $t_3$, the microcontroller completes acquisition of the secondary current signal, calculation of the primary current and power off the drive module of the secondary coil. At a moment $t_4$, output of the measured current result is completed. $t_6$ to $t_{10}$ is a next current measurement cycle (whether there is an interval between $t_5$ and $t_6$ can be set according to an actual situation). In each measurement cycle, the drive module and the secondary coil 2 are powered on with the voltage U1 only in a period of time from the moment $t_2$ to the moment $t_3$, and are powered off at other time, in which no power is consumed. An input moment $t_2$ of the primary current can be any time in a period of time from $t_0$ to $t_1$, including $t_0$ and $t_1$.

The standby mode: When the current sensor is in the normal operating mode or the low-power mode, after an absolute value of the primary current is less than a preset current threshold $I_1$ for a predetermined time t (which is preset), the current sensor enters the standby mode. In the standby mode, a temperature sensor monitors temperature of the current sensor in real time, and the microcontroller monitors the primary current but does not transmit a signal to the client. When the absolute value of the primary current is greater than the current threshold $I_1$, the current sensor automatically returns to the normal operating mode, and the microcontroller transmits a current measurement result to the outside. A value of $I_1$ is very small, so that in this operating mode, the primary conductor 4 has almost no primary current. The output terminal of the signal input/output interface module of the current sensor does not work, thereby saving part of power consumption of the module.

The sleep mode: After a period of time t' in the standby mode, the current sensor enters the sleep mode. The microcontroller controls the power supply module to power off the secondary coil 2, the drive module, and the temperature sensor. The signal input/output interface module or the wake-up port is in a monitoring mode. The microcontroller works in the sleep mode, and monitors only the signal input/output interface module to receive a client command. The client inputs a wake-up command through the signal input/output interface module, and the microcontroller controls the current sensor to enter the normal operating mode according to the wake-up command.

In Embodiment 1, power consumption of the current sensor is composed of power consumption $P_{sense}$ of the magnetic sensor, power consumption $P_{drive}$ of the drive module, power consumption $P_{coil}$ of the secondary coil, power consumption $P_{com}$ of the signal input/output interface module, power consumption $P_{mcu}$ of the microcontroller, and efficiency $\eta$ of the power supply module (power consumption of the temperature sensor is relatively low and can be ignored). A specific calculation formula of the power consumption $P_{sum}$ of the current sensor is as follows:

$$P_{sum}=(P_{sense}+P_{drive}+P_{coil}+P_{com}+P_{mcu})/\eta \qquad (2).$$

In the normal operating mode, all modules of the current sensor are powered on and in a working state and maximum power consumption is $P_1$.

In the low-power mode, because power supply time is greatly reduced, the power consumption $P_{sense}$ of the magnetic sensor 3, the power consumption $P_{drive}$ of the drive module, and the power consumption $P_{coil}$ of the secondary coil 2 are greatly reduced. The power consumption $P_{com}$ of the signal input/output interface module and the power consumption $P_{mcu}$ of the microcontroller remain unchanged. In this case, total power consumption of the current sensor is $P_2$, and $P_2<P_1$.

In the standby mode, the current sensor monitors only a tiny inputted primary current (less than $I_1$), and does not perform transmission to the outside. That is, the power consumption of the output terminal of the signal input/output interface module is 0, and therefore $P_{com}$ decreases greatly. Because $I_1$ is very small, the total power consumption of the current sensor in this case is $P_3$, and $P_3<P_2$.

In the sleep mode, the drive module is powered off, and there is no current on the secondary coil 2. The microcontroller works in a sleep state and monitors only an input signal on the signal input/output interface module, so that the total power consumption $P_4$ of the current sensor in this case is the smallest, that is, $P_4<P_3<P_2<P_1$.

As shown in FIG. 5, comparison between power consumption of the current sensor only in the normal mode and power consumption of the current sensor in the low-power intelligent control mode in Embodiment 1 is as follows: In a same current detection environment and solution, it can be found by comparing temperature rises of the current sensor in the normal operating mode and in the low-power intelligent control mode that:

In Embodiment 1, after temperature of the current sensor only in the normal operating mode is stabilized, the temperature rise reaches 65°C. In Embodiment 1, after the current sensor enables the low-power intelligent control mode, the current sensor works in the normal mode after being powered on. Temperature in the current sensor rises rapidly. At the 600th second, the temperature sensor in the current sensor detects that the temperature is higher than a preset temperature threshold $T_1$, the microcontroller is triggered to enable the low-power mode (the microcontroller can alternatively be triggered by a control signal inputted by an external client). The temperature rise of the current sensor drops to 42°C, which is lower than the temperature rise of the conventional sensor by about 23°C, and the temperature rise drops by about 35.3%.

Embodiment 2

As shown in FIG. 7, a low-power intelligent current sensor includes a magnetic core 1, a secondary coil 2 wound around the magnetic core 1, a magnetic sensor 3 disposed in the magnetic core 1, and a current detection circuit, the current detection circuit including a power supply module, a drive module, a microcontroller, a temperature detection module, a signal output interface module, and a wake-up port. Different from Embodiment 1, in Embodiment 2, the signal input/output interface module is replaced with the output interface module. That is, a function of receiving an external input signal is disabled. In addition, the wake-up port is added, the wake-up port being in signal connection to the microcontroller. Other device structures and connection relationships are all the same as those of the Embodiment 1. After the wake-up port is added, the four operating modes of the current sensor remain unchanged, but when the current sensor is in the sleep mode, the current sensor needs to be woken up through the wake-up port.

The temperature detection module in the technical solutions described in Embodiment 1 and Embodiment 2 can be replaced with a microcontroller with a temperature detection function. That is, the temperature detection module is integrated in the microcontroller, which belongs to the related art. A control method of an operating mode of the microcontroller is the same as that of Embodiment 1 or Embodiment 2.

The foregoing descriptions are merely exemplary implementations of the present disclosure. It should be noted that a person of ordinary skill in the art may make improvements and polishing without departing from the scope of the present disclosure and the improvements and polishing shall fall within the protection scope of the present disclosure.

**Claims**

1. A low-power intelligent current sensor, comprising a magnetic core (1), a secondary coil (2) wound around the magnetic core, and a magnetic sensor (3) disposed in the magnetic core, and further comprising a current detection circuit, the current detection circuit comprising a power supply module, a drive module, a microcontroller, a temperature detection module, and a signal input/output interface module, a signal output terminal of the magnetic sensor being connected to a signal input terminal of the drive module, the drive module being electrically connected to each of two ends of the secondary coil, the microcontroller being in signal connection to each of the power supply module, the drive module, the temperature detection module, and the signal input/output interface module, the power supply module being connected to each of the drive module, the microcontroller, the temperature detection module, and the signal input/output interface module, an input terminal and an output terminal of the signal input/output interface module being each in signal connection to a client, and the temperature detection module being installed in the current sensor, and being configured for detecting a temperature of the current sensor;

wherein the power supply module comprises a direct current to direct current (DC-DC) converter, a first linear regulator, and a second linear regulator; input terminals of the DC-DC converter, the first linear regulator, and the second linear regulator are all connected to a power supply voltage Vcc of the current sensor; the power supply module provides a unipolar power supply for the sensor; an output voltage U2 of the first linear regulator is electrically connected to each of the drive module, the temperature detection module, and the signal input/output interface module; an output voltage U3 of the second linear regulator is electrically connected to the microcontroller; and three power supply circuits in the power supply module are all controlled by the microcontroller to be on or off, **characterized by** an output voltage U1 of the DC-DC converter is electrically connected to the secondary coil through the drive module; the output voltage U1 is controlled by the microcontroller to power on or off the secondary coil

2. The low-power intelligent current sensor according to claim 1, wherein the signal input/output interface module is replaced with a signal output interface module, and in addition, a wake-up port is further disposed, the wake-up port being in signal connection to the microcontroller.

3. A control method of an operating mode of the low-power intelligent current sensor according to anyone of claims 1 and 2, wherein a normal operating mode, a low-power mode, a standby mode, and a sleep mode are comprised, the specific control method being as follows:

(1) the normal operating mode: the current sensor enters the normal operating mode after being powered on and the normal operating mode comprises: the microcontroller controlling the power supply module to continuously supply power to the secondary coil, and monitoring the temperature of the current sensor in real time through the temperature detection module, the microcontroller acquiring current information of a sampling resistor in the drive module in real time, calculating a magnitude of a primary current according to the acquired current information, and outputting a current measurement result to the client through the signal input/output interface module or the signal output interface module, and the microcontroller controlling the current sensor to exit from the normal operating mode and enter another mode according to an external command or an internal trigger condition;

(2) the low-power mode: during a process of temperature rise, when the temperature detection module detects that the temperature of the current sensor is greater than a preset temperature threshold $T_1$, the current sensor enters the low-power mode, and within each preset current measurement cycle, the microcontroller controls the power supply module to perform a power-on and power-off operation on the secondary coil, wherein the current sensor is powered off immediately after completing current measurement within a power-on cycle of the secondary coil; during a process of temperature drop, when the temperature detection module detects that the temperature of the current sensor is less than a preset temperature threshold $T_2$, the microcontroller controls the current sensor to enter the normal operating mode or the standby mode;

(3) the standby mode: when the current sensor is in the normal operating mode or the low-power mode, after an absolute value of the primary current is less than a preset current threshold $I_1$ for a predetermined time t, the current sensor enters the standby mode; in the standby mode, the temperature sensor monitors the temperature of the current sensor in real time, the microcontroller monitors the primary current but transmits no signal to the client; when the absolute value of the primary current is greater than the current threshold $I_1$, the current sensor automatically returns to the normal operating mode, and the microcontroller transmits a current measurement result to outside; and

(4) the sleep mode: after a period of time t' in the standby mode, the current sensor enters the sleep mode, wherein the microcontroller controls the power supply module to power off the secondary coil, the temperature sensor, and the drive module, the signal input/output interface module or the wake-up port is in a monitoring mode, the microcontroller works in the sleep mode, and monitors only the signal input/output interface module or the wake-up port, to receive a client command, the client inputs a wake-up command through the signal input/output interface module or the wake-up port, and the microcontroller controls the current sensor to enter the normal operating mode according to the wake-up command.

**Patentansprüche**

1. Intelligenter Stromsensor mit geringem Stromverbrauch, der einen Magnetkern (1), eine um den Magnetkern gewickelte Sekundärspule (2) und eine im Magnetkern angeordneten Magnetsensor (3) umfasst und ferner eine Stromerfassungsschaltung umfasst, wobei die Stromerfassungsschaltung ein Netzteilmodul, ein Antriebsmodul, einen Mikrocontroller, ein Temperaturerfassungsmodul und ein Schnittstellenmodul zur Signaleingabe/-ausgabe umfasst, wobei eine Signalausgangsklemme des Magnetsensors mit einer Signaleingangsklemme des Antriebsmoduls verbunden ist, wobei das Antriebsmodul elektrisch mit jedem beider Enden der Sekundärspule verbunden ist, wobei der Mikrocontroller jeweils mit dem Netzteilmodul, dem Antriebsmodul, dem Temperaturerfassungsmodul und dem Schnittstellenmodul zur Signaleingabe/-ausgabe in Signalverbindung steht, wobei das Netzteilmodul jeweils mit dem Antriebsmodul, dem Mikrocontroller, dem Temperaturerfassungsmodul und dem Schnittstellenmodul zur Signaleingabe/-ausgabe verbunden ist, wobei eine Eingangsklemme und eine Ausgangsklemme des Schnittstellenmoduls zur Signaleingabe/-ausgabe jeweils mit einem Client in Signalverbindung stehen, und wobei das Temperaturerfassungsmodul im Stromsensor installiert ist und zum Erfassen einer Temperatur des Stromsensors konfiguriert ist;
   wobei das Netzteilmodul einen Gleichspannungswandler, also DC/DC-Wandler, einen ersten Linearregler und einen zweiten Linearregler umfasst; wobei Eingangsklemmen des DC/DC-Wandlers des ersten Linearreglers und des zweiten Linearreglers alle mit einer Versorgungsspannung Vcc des Stromsensors verbunden sind; wobei das Netzteilmodul eine unipolare Stromversorgung für den Sensor bereitstellt; wobei eine Ausgangsspannung U2 des ersten Linearreglers jeweils elektrisch mit dem Antriebsmodul, dem Temperaturerfassungsmodul und dem Schnittstellenmodul zur Signaleingabe/-ausgabe verbunden wird; wobei eine Ausgangsspannung U3 des zweiten Linearreglers elektrisch mit dem Mikrocontroller verbunden ist, und wobei drei Stromversorgungsschaltungen im Netzteilmodul alle durch den Mikrocontroller so gesteuert werden, dass sie ein- oder ausgeschaltet sind, **dadurch gekennzeichnet, dass** eine Ausgangsspannung U1 des DC/DC-Wandlers über das Antriebsmodul elektrisch mit der Sekundärspule verbunden ist, wobei die Ausgangsspannung U1 des DC/DC-Wandlers durch den Mikrocontroller gesteuert wird, um die Sekundärspule ein- oder auszuschalten.

2. Intelligenter Stromsensor mit geringem Stromverbrauch nach Anspruch 1, wobei das Schnittstellenmodul zur Signaleingabe/-ausgabe durch ein Schnittstellenmodul zur Signalausgabe ersetzt wird und ein Weckport zusätzlich vorgesehen ist, wobei der Weckport mit dem Mikrocontroller in Signalverbindung steht.

3. Steuerverfahren für einen Betriebsmodus des intelligenten Stromsensors mit geringem Stromverbrauch nach einem der Ansprüche 1 und 2, wobei ein normaler Betriebsmodus, ein Low-Power-Modus, ein Standby-Modus und ein Schlafmodus vorgesehen sind, wobei das spezifische Steuerverfahren wie folgt ist:

   (1) der normale Betriebsmodus: der Stromsensor wechselt nach dem Einschalten in den normalen Betriebsmodus und der normale Betriebsmodus umfasst: Steuern des Netzteilmoduls durch den Mikrocontroller, um die Sekundärspule kontinuierlich mit Strom zu versorgen, und Überwachen der Temperatur des Stromsensors in Echtzeit durch das Temperaturerfassungsmodul, Erwerben von Strominformationen eines Abtastwiderstands im Antriebsmodul durch den Mikrocontroller in Echtzeit; Berechnen einer Größe eines Primärstroms abhängig von den erworbenen Strominformationen, und Ausgeben eines Strommessergebnisses an den Client über das Schnittstellenmodul zur Signaleingabe/-ausgabe oder das Schnittstellenmodul zur Signalausgabe, und Steuern des Stromsensors durch den Mikrocontroller, so dass er abhängig von einem externen Befehl oder einer internen Auslösebedingung den normalen Betriebsmodus verlässt und in einen anderen Modus wechselt;
   (2) der Low-Power-Modus: während eines Prozesses eines Temperaturanstiegs und in Fall, in dem das Temperaturerfassungsmodul erfasst, dass die Temperatur des Stromsensors größer als einen voreingestellten Temperaturschwellenwert $T_1$ ist, wechselt der Stromsensor in den Low-Power-Modus, wobei innerhalb jedes voreingestellten Strommesszyklus das Netzteilmodul durch den Mikrocontroller so gesteuert wird, dass es einen Ein- und Ausschaltvorgang an der Sekundärspule durchführt, wobei der Stromsensor unmittelbar nach Abschluss der Strommessung innerhalb eines Einschaltzyklus der Sekundärspule ausgeschaltet wird; während eines Prozesses des Temperaturabfalls und im Fall, in dem das Temperaturerfassungsmodul erfasst, dass die Temperatur des Stromsensors kleiner als einen voreingestellten Temperaturschwellenwert $T_2$ ist, steuert der Mikrocontroller den Stromsensor so, dass er in den normalen Betriebsmodus oder den Standby-Modus wechselt;
   (3) der Standby-Modus: wenn sich der Stromsensor im normalen Betriebsmodus oder im Low-Power-Modus befindet, wechselt der Stromsensor in den Standby-Modus, nachdem ein Absolutwert des Primärstroms für eine vorgebestimmte Zeit t kleiner als ein voreingestellter Stromschwellenwert $I_1$ ist, wobei im Standby-Modus der Temperatursensor die Temperatur des Stromsensors in Echtzeit überwacht, wobei der Mikrocontroller den Primärstrom überwacht, jedoch kein Signal an den Client überträgt; wenn der Absolutwert des Primärstroms größer als der Stromschwellenwert I$_1$ ist, kehrt der Stromsensor automatisch in den normalen Betriebsmodus zurück und überträgt der Mikrocontroller ein Strommessergebnis nach außen; und

(4) der Schlafmodus: nach einer Zeitspanne t' im Standby-Modus wechselt der Stromsensor in den Schlafmodus, wobei der Mikrocontroller das Netzteilmodul steuert, um die Sekundärspule, den Temperatursensor und das Antriebsmodul auszuschalten, wobei sich das Schnittstellenmodul zur Signaleingabe/-ausgabe oder der Weckport in einem Überwachungsmodus befindet, wobei der Mikrocontroller im Schlafmodus betrieben ist und lediglich das Schnittstellenmodul zur Signaleingabe/-ausgabe oder den Weckport überwacht, um einen Clientbefehl zu empfangen, wobei der Client einen Weckbefehl über das Schnittstellenmodul zur Signaleingabe/-ausgabe oder den Weckport eingibt, und wobei der Mikrocontroller abhängig vom Weckbefehl den Stromsensor so steuert, dass er in den normalen Betriebsmodus wechselt.

**Revendications**

1. Capteur de courant intelligent à faible puissance, comprenant un noyau magnétique (1), une bobine secondaire (2) enroulée autour du noyau magnétique et un capteur magnétique (3) disposé dans le noyau magnétique, et comprenant en outre un circuit de détection de courant, le circuit de détection de courant comprenant un module d'alimentation, un module d'entraînement, un microcontrôleur, un module de détection de température et un module d'interface d'entrée/sortie de signal, une borne de sortie de signal du capteur magnétique étant connectée à une borne d'entrée de signal du module d'entraînement, le module d'entraînement étant connecté électriquement à chacune de deux extrémités de la bobine secondaire, le microcontrôleur étant en connexion de signal avec chacune du module d'alimentation, du module d'entraînement, du module de détection de température et du module d'interface d'entrée/sortie de signal, le module d'alimentation étant connecté à chacun du module d'entraînement, le microcontrôleur, du module de détection de température et du module d'interface d'entrée/sortie de signal, une borne d'entrée et une borne de sortie du module d'interface d'entrée/sortie de signal étant chacune en connexion de signal avec un client, et le module de détection de température étant installé dans le capteur de courant, et étant configuré pour détecter une température du capteur de courant ;

   dans lequel le module d'alimentation comprend un convertisseur courant continu à courant continu (DC-DC), un premier régulateur linéaire et un second régulateur linéaire ; des bornes d'entrée du convertisseur DC-DC, du premier régulateur linéaire et du second régulateur linéaire sont toutes connectées à une tension d'alimentation Vcc du capteur de courant ; le module d'alimentation fournit une alimentation unipolaire au capteur ; une tension de sortie U2 du premier régulateur linéaire est connectée électriquement à chacun du module d'entraînement, du module de détection de température et du module d'interface d'entrée/sortie de signal ; une tension de sortie U3 du second régulateur linéaire est connectée électriquement au microcontrôleur ; et trois circuits d'alimentation dans le module d'alimentation sont tous commandés par le microcontrôleur à être activés ou désactivés, **caractérisé en ce qu'**une tension de sortie U1 du convertisseur DC-DC est connectée électriquement à la bobine secondaire par l'intermédiaire du module d'entraînement ; la tension de sortie U1 est contrôlée par le microcontrôleur à mettre la bobine secondaire sous tension ou hors tension.

2. Capteur de courant intelligent à faible puissance selon la revendication 1, dans lequel le module d'interface d'entrée/sortie de signal est remplacé par un module d'interface de sortie de signal, et de plus, un port de réveil est en outre disposé, le port de réveil étant en connexion de signal avec microcontrôleur.

3. Procédé de commande d'un mode de fonctionnement du capteur de courant intelligent à faible puissance selon l'une quelconque des revendications 1 et 2, dans lequel un mode de fonctionnement normal, un mode de faible puissance, un mode d'attente et un mode de sommeil sont compris, le procédé de commande spécifique étant le suivant :

   (1) le mode de fonctionnement normal : une fois mis sous tension, le capteur de courant passe en mode de fonctionnement normal et le mode de fonctionnement normal comprend : le microcontrôleur commande le module d'alimentation à alimenter en continu la bobine secondaire, le module de détection de température surveille la température du capteur de courant en temps réel, le microcontrôleur acquiert des informations de courant d'une résistance d'échantillonnage dans le module d'entraînement en temps réel, calcule une amplitude d'un courant primaire en fonction des informations de courant acquises, et transmet un résultat de mesure de courant au client par l'intermédiaire du module d'interface d'entrée/sortie de signal ou du module d'interface de sortie de signal, et le microcontrôleur commande le capteur de courant à sortir du mode de fonctionnement normal et à passer en autre mode en fonction d'une instruction extérieure ou d'une condition de déclenchement intérieure ;

   (2) le mode de faible puissance : au cours d'élévation de température, lorsque le module de détection de température détecte que la température du capteur de courant est supérieure à un seuil de température prédéfini $T_1$, le capteur de courant passe en mode de faible puissance, et dans chaque cycle de mesure de courant prédéfini, le microcontrôleur commande le module d'alimentation à effectuer une opération de mise sous tension et de mise hors tension sur la bobine secondaire, dans lequel le capteur de courant est mis hors tension immédiatement une fois la mesure du courant complétée dans un cycle de mise sous tension de la bobine secondaire ; au cours de chute de température, lorsque le module de détection de température détecte que la température du capteur de courant est inférieure à un seuil de température prédéfini $T_2$, le microcontrôleur commande le capteur de courant à passer en mode de fonctionnement normal ou en mode d'attente ;

(3) le mode d'attente : lorsque le capteur de courant est en mode de fonctionnement normal ou en mode de faible puissance, une fois qu'une valeur absolue du courant primaire est inférieure à un seuil de courant prédéfini $I_1$ pour un temps t prédéterminé, le capteur de courant passe en mode d'attente ; en mode d'attente, le capteur de température surveille la température du capteur de courant en temps réel, le microcontrôleur surveille le courant primaire mais ne transmet aucun signal au client ; lorsque la valeur absolue du courant primaire est supérieure au seuil de courant $I_1$, le capteur de courant repasse automatiquement en mode de fonctionnement normal et le microcontrôleur transmet un résultat de mesure de courant à l'extérieur ; et

(4) le mode de sommeil : à la fin d'une durée t' en mode d'attente, le capteur de courant passe en mode de sommeil, dans lequel le microcontrôleur commande le module d'alimentation à mettre la bobine secondaire, le capteur de température et le module d'entraînement hors tension, le module d'interface d'entrée/sortie de signal ou le port de réveil est en mode de surveillance, le microcontrôleur fonctionne en mode de sommeil et ne surveille que le module d'interface d'entrée/sortie de signal ou le port de réveil pour recevoir une instruction depuis le client, le client entre une instruction de réveil par l'intermédiaire du module d'interface d'entrée/sortie de signal ou du port de réveil, et le microcontrôleur commande le capteur de courant à passer en mode de fonctionnement normal conformément à l'instruction de réveil.

FIG. 1

FIG. 2

FIG. 3

FIG. 4

FIG. 5

FIG. 6

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 212483673 U